# EUROPÄISCHE PATENTSCHRIFT

(11) **EP 0 998 756 B1**
(45) Veröffentlichungstag und Bekanntmachung des Hinweises auf die Patenterteilung: **13.07.2005**
(21) Anmeldenummer: 98947310.3
(22) Anmeldetag: 20.07.1998
(51) Int. Cl.: H01L 21/60

(54) **VORRICHTUNG UND VERFAHREN ZUR HERSTELLUNG EINER CHIP-SUBSTRAT-VERBINDUNG**
DEVICE AND METHOD FOR PRODUCING A CHIP-SUBSTRATE CONNECTION
PROCEDE ET DISPOSITIF POUR LA REALISATION D'UN ASSEMBLAGE PUCE-SUBSTRAT

(30) Priorität: 23.07.1997 DE 19731740
(43) Veröffentlichungstag der Anmeldung: 10.05.2000
(73) Patentinhaber: Infineon Technologies AG, 81669 München (DE)
(72) Erfinder: GRÖTSCH, Stefan, D-93053 Regensburg (DE); ALTHAUS, Hans-Ludwig, D-93138 Lappersdorf (DE); SPÄTH, Werner, D-83607 Holzkirchen (DE); BOGNER, Georg, D-93138 Hainsacker (DE)
(74) Vertreter: Müller, Wolfram Hubertus, Dipl.-Phys.
(86) Internationale Anmeldenummer: PCT/DE1998/002027
(87) Internationale Veröffentlichungsnummer: WO 1999/005719

(56) Entgegenhaltungen:
- GB-A- 2 244 374
- US-A- 4 954 453
- C.KARWATOWSKI ET AL.: "Inspection for quartz insulation on laser-weldable metal layers in semiconductor device" IBM TECHNICAL DISCLOSURE BULLETIN , Bd. 24, Nr. 8, Januar 1982, Seite 4286 XP002086307 New York
- B.C.HENRY ET AL.: "Semiconductor structure with infrared energy absorption layer" IBM TECHNICAL DISCLOSURE BULLETIN, Bd. 22, Nr. 2, Juli 1909, Seite 681 XP002086308 New York

## Beschreibung

Die Erfindung betrifft eine Vorrichtung und ein Verfahren zur Herstellung einer Chip-Substrat-Verbindung, insbesondere durch Löten eines Halbleiterchips auf einem Substrat, welche Vorrichtung einen Träger, auf bzw. an dem das Substrat vorübergehend abgestützt ist, und eine der Chip-Substrat-Verbindung zugeordnete Heizeinrichtung aufweist.

Bei der Verbindung eines Halbleiterchips mit seiner Rückseite auf ein Substrat, welches üblicherweise als Chip- oder Die-Bonding bezeichnet wird, müssen die Anforderungen hinsichtlich einer ausreichenden mechanischen Befestigung sowie einer guten thermischen und elektrischen Leitfähigkeit je nach Anwendungsfall einzeln oder gemeinsam erfüllt werden. Eine besondere Rolle spielt die Verträglichkeit von Chip und Substrat, d.h. der Anpassung beider Verbindungspartner in ihrem Ausdehnungsverhalten bei thermischer Belastung. Derzeit sind im Wesentlichen drei zu unterscheidende Verfahren der Chipbefestigung üblich: Legieren (Hartlöten), Löten (Weichlöten), und Kleben. Das bevorzugte Anwendungsgebiet gemäß der vorliegenden Erfindung ist Löten (Weichlöten), bei welchem Verfahrensprinzip im Gegensatz etwa zum eutektischen Si/Au-Hartlöten für die Chipbefestigung kein Silizium des Chips in Lösung geht. Vielmehr werden beim Weichlöten bei Temperaturen deutlich unter 450° Celsius und damit auch wieder wesentlich unter dem Schmelzpunkt der beteiligten Metalle die metallisierten Verbindungspartner durch schmelzendes Lot benetzt und verbunden. Die beim Weichlöten vorkommenden Temperaturen gestatten zwar die Anwendung des Verfahrens auf allen üblichen Substraten, es wird aber vorzugsweise auf metallischen Systemträgern (sogenannten Leadframes) und keramischen Gehäuseböden angewandt. Generell ist bei der Chipbefestigung durch Löten eine Anpassung im thermischen Ausdehnungsverhalten der Verbindungspartner erwünscht, jedoch sind hier die Grenzen weiter gesteckt als beim Legieren.

Eine unbehandelte Chiprückseite lasst sich durch Weichlot normalerweise nicht benetzen, sie muss metallisiert werden. Neben der auch hier gültigen Forderung nach guter Haftung auf dem Silizium und sperrschichtfreiem Übergang kommt die nach guter Lötfähigkeit, d.h. Benetzbarkeit hinzu. So haben sich fur sperrschichtfreie Übergange auf n-Si-Schichten hauptsächlich Lote aus Ti, NiSi und AuSb, auf p-Si-Schichten solche aus Al, Cr und Au bewahrt. Die Substratoberflache ist üblicherweise chemisch vernickelt. Werden niedrige Löttemperaturen gewünscht, kommt auch eine galvanische Versilberung in Betracht.

Als Heizquellen für die Beheizung der zu verbindenden Materialien und Halbleiterchips werden bislang widerstandsbeheizte Lötaufnahmen oder Heizwicklungen verwendet. Diese Heizquellen haben aber den Nachteil, dass ihre Aufheizgeschwindigkeit bis zur Löttemperatur zu lang ist (in aller Regel wesentlich länger als 1 s), so dass eine Oxidation des Lotes stattfindet und somit Schutzgase oder reduzierende Atmosphären verwendet werden müssen.

Aus der EP-A-321 142 A2 ist ein diodenlaserunterstütztes Lötverfahren bekannt geworden, bei dem ein die zu verbindenden Teile glockenförmig übergreifendes Heizelement aus einem für Laserstrahlung absorptivem Material vorgesehen ist, welches durch Bestrahlung mit Laserlicht aufgeheizt wird, und Wärmeenergie an die zu verbindenden Teile abgibt. Das Heizelement befindet sich nicht in unmittelbar mechanischem Kontakt mit den zu verbindenden Teilen, sondern es sind Offnungen vorgesehen, die eine ausreichende Luftzirkulation gewährleisten.

Aus der GB-A-2244374 ist ein Verfahren zur laserunterstützten Lötverbindung eines Halbleiterwafersubstrates und einer integrierten Schaltung bekannt geworden, bei dem die Infrarotstrahlung des Lasers durch das Wafersubstrat unmittelbar an die zu lotende Verbindung gerichtet wird.

Weitere laser- bzw. strahlungsunterstützte Lötverfahren sind aus IBM TDB vol. 22 no. 2, July 1979, IBM TDB vol. 24 no. 8, Jan. 1982 und US-A-4 954 453 bekannt geworden.

Der Erfindung liegt die Aufgabe zugrunde, eine Vorrichtung und ein Verfahren zur Herstellung einer Chip-Substrat-Verbindung, insbesondere durch Weichlöten für die Befestigung eines Halbleiterchips auf einem Substrat wie beispielsweise einem metallischen Systemträger oder keramischen Gehäuseboden, anzugeben, bei der bzw. bei dem eine Aufheizung zur Herstellung der Lötverbindung auf mehr als typischerweise 350° Celsius in sehr kurzer Zeit, d.h. etwa 1 s oder darunter ermöglicht wird, und gleichzeitig die Wärmebelastung des betroffenen Halbleiterchips möglichst gering zu halten.

Diese Aufgabe wird vorrichtungsmäßig durch Anspruch 1, verfahrensmäßig durch Anspruch 10 gelöst.

Erfindungsgemäß ist vorgesehen, dass die Heizeinrichtung eine Strahlungsquelle besitzt, und der Träger zur Abstützung des Substrates als Bestandteil der Heizeinrichtung einen der Chip-Substrat-Verbindung zugeordneten, im Betrieb der Vorrichtung von der Strahlungsquelle mit elektromagnetischer Strahlung beheizten Wärmekörper aufweist. Dem Prinzip der Erfindung folgend ist vorgesehen, dass die Strahlungsquelle ein Laser mit einer Laserstrahlung im Infrarot-wellenlängenbereich darstellt.

Gegenüber den bislang verwendeten Heizquellen beim Weichlöten für die Chipbefestigung bietet die Erfindung insbesondere folgende Vorteile:
- Durch die Verwendung von Laserstrahlung im infraroten Wellenlängenbereich um typischerweise 950 nm kann die Lötverbindung von Halbleiterchip und Substrat in sehr kurzer Zeit, d.h. typischerweise in etwa 1 s oder darunter auf mehr als etwa 350° Celsius aufgeheizt werden, wobei die verwendete Laserleistung entsprechend dem mit der Wärmestrahlung beheizten Wärmekörper passend gewählt wird derart, dass der Wärmekörper eine ausreichend hohe Absorption der Laserstrahlung besitzt, damit die infrarote Lichtenergie in Wärmeenergie umgewandelt werden kann, und andererseits die Laserleistung aber nicht so groß ist, dass der zu verbindende Halbleiterchip einer zu starken Wärmebelastung ausgesetzt wird.
- Durch die sehr großen Aufheizgeschwindigkeiten bis zur Löttemperatur wird eine Oxidation des Lotes vermieden, so dass auch ohne Einsatz von Schutzgasen oder reduzierenden Atmosphären gearbeitet werden kann. Der Einsatz von Lötflussmitteln kann aufgrund der sehr kurzen Zeitintervalle bis zur Erreichung der Löttemperaturen entfallen.
- Die kurzzeitige Aufheizung kann annähernd punktuell und damit chipweise erfolgen, so dass in kontrollierter Weise nur der jeweils betroffene Halbleiterchip zur Herstellung der Lötverbindung aufgeheizt wird, die davon benachbarten Halbleiterchips noch keine wesentliche Temperaturerhöhung erfahren.

Unter dem Begriff "Chip-Substrat-Verbindung" sollen nicht nur Verbindungen einzelner, aus dem Waferverbund geschnittener oder gesägter Chips verstanden werden, sondern auch Verbindungen von mehreren, noch zusammenhängenden Halbleiterchips aus dem Waferverbund, sogenannter Chipbarren.

Von vorteil ist vorgesehen, dass der der Chip-Substrat-Verbindung zugeordnete Wärmekörper der Heizeinrichtung ein für die Wärmestrahlung der Strahlungsquelle transparentes oder wenigstens durchscheinendes Material aufweist. Quarz als bevorzugtes Material für den Wärmekörper hat aufgrund seiner geringen Ausdehnung den Vorteil, dass die kurzen, lokal auftretenden Temperaturschwankungen nicht zu Rissen oder Brüchen führen.

Dem Prinzip der Erfindung folgend ist des Weiteren vorgesehen, dass der Wärmekörper auf seiner der Chip-Substrat-Verbindung zugewandten Seite ein Material hoher Absorption der von der Strahlungsquelle gespeisten Lichtstrahlung aufweist. Von besonderem Vorteil ist das Material hoher Absorption als dünne Metallschicht, insbesondere dünne Chrom-Schicht auf der der Chip-Substrat-Verbindung zugewandten Oberfläche des Wärmekörpers aufgetragen. Im Falle eines transparenten Wärmekörpers wie beispielsweise Quarz beträgt die Stärke der aufgebrachten Chrom-Schicht vorteilhafterweise einige 100 nm, maximal bis etwa einige µm, oder auch darüber, sofern keine Probleme im Hinblick auf eine ausreichende Haftung der Chrom-Schicht auf dem Wärmekörper zu erwarten sind. Das Material hoher Laserabsorption auf dem Wärmekörper bietet entsprechend der Erfindung vor allem den Vorteil, eine genügend hohe Absorption der Laserstrahlung zu erzielen, um die infrarote Lichtenergie in Wärmeenergie umzuwandeln. Gleichzeitig kann durch die gute Absorption dieses Materials die verwendete Laserleistung verringert sein, wodurch wiederum die Verwendung der bereits zur Verfügung stehenden, besonders gut geeigneten Laserquellen wie insbesondere Halbleiterlaserdioden zur Herstellung einer Chip-Substrat-Verbindung nach der Erfindung eröffnet wird.

Im Falle eines mit dem Laserabsorptionsmaterial beschichteten Wärmekörpers sollte der Wärmekörper selbst ein schlechter Wärmeleiter und idealerweise transparent für die Laserstrahlung sein, oder sollte im Falle guter Wärmeleitfähigkeit eine hinreichend geringe Wärmekapazität besitzen. Auf diese Weise kann in beiden Fällen der Anteil der nicht zum Aufheizen der Primärmaterialien verwendeten Energie gering gehalten werden. Auch in diesem Sinne wird einem Wärmekörper aus Quarz, der mit einer als Energieabsorber dienenden Chrom-Schicht versehen ist, der Vorzug gegeben.

Von besonderem Vorteil kann vorgesehen sein, dass die Ausdehnung des Materials hoher Absorption auf den zu erwärmenden Abschnitt des unmittelbar betroffenen Halbleiterchips der Chip-Substrat-Verbindung begrenzt ist. Dadurch wird die Möglichkeit eröffnet, die Chips einzeln zu bonden, ohne benachbarte Chips unnötig aufzuheizen.

Nachfolgend wird die Erfindung anhand eines in der Zeichnung dargestellten Ausführungsbeispiels weiter erläutert. Im Einzelnen zeigt die Darstellung in:

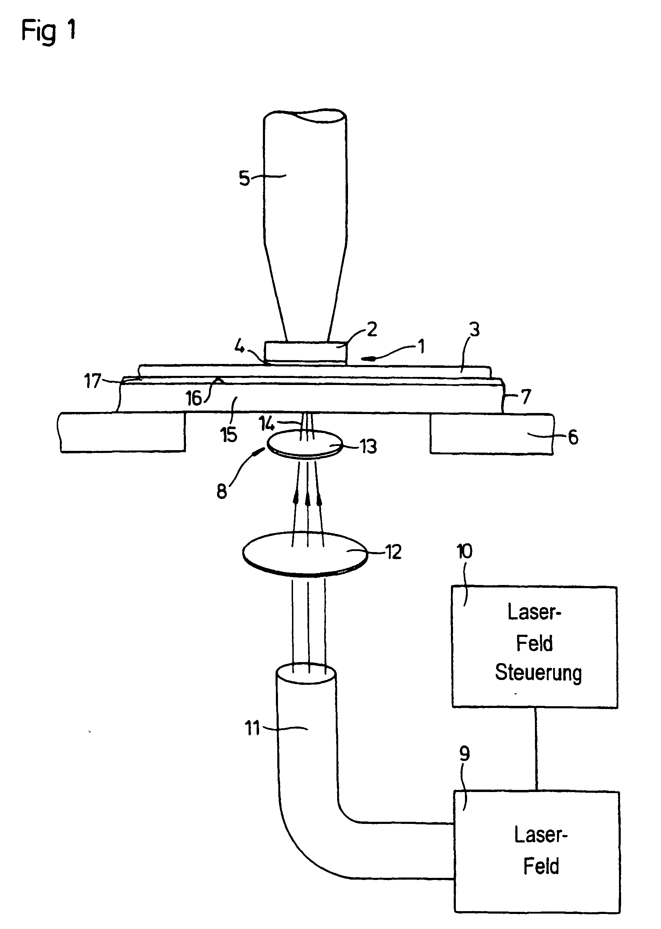

- Figur 1: eine schematische Schnittansicht einer Vorrichtung zur Herstellung einer Chip-Substrat-Verbindung durch Weichlöten eines Halbleiterchips unter Verwendung einer IR-Laserquelle.

Das in Figur 1 dargestellte Ausführungsbeispiel umfaßt eine erfindungsgemäße Vorrichtung zur Herstellung einer Chip-Substrat-Verbindung 1 vermittels Weichlöten eines einzelnen Halbleiterchips 2 auf einem Substrat 3. Das Bezugszeichen 4 bezeichnet der Einfachheit wegen schematisch sämtliche auf der Rückseite des Halbleiterchips 2 zur Herstellung der Chip-Substrat-Verbindung erforderlichen Materialien, also Weichlot und gegebenenfalls weitere lötfähige Deckschichten. Das als Unterlage zur Befestigung des Halbleiterchips dienende Substrat 3 ist in Figur 1 ebenfalls lediglich schematisch und ausschnittsweise angedeutet; dargestellt ist ein vorgefertigter metallener Systemträger (sogenanntes Leadframe), der insbesondere für die Verwendung in Kunststoffgehäusen eine sehr weit verbreitete Substratform ist. Das Substrat 3 wird normalerweise in Endlosform von einem Metallband der Vorrichtung zur Herstellung der Chip-Substrat-Verbindung zugeführt, ein einzelner Halbleiterchip vermittels einem speziell geformten Saugstempel 5 von einer (nicht näher dargestellten) Klebefolie entnommen, auf welcher der Chip als Scheibe zum Sägen geklebt wurde, und auf der dafür vorgesehenen Stelle des Substrates 3 wie in Figur 1 angedeutet positioniert und abgelegt. Daran anschließend erfolgt die Verbindung von Halbleiterchip 2 und Substrat 3 durch Weichlöten vermittels der erfindungsgemäßen Vorrichtung. Diese umfasst einen auf einem Tisch 6 befestigten Träger 7, auf bzw. an dem das Substrat 3 vorübergehend abgestützt ist, sowie eine der Chip-Substrat-Verbindung 1 zugeordnete Heizeinrichtung 8.

Erfindungsgemäß umfasst die Heizeinrichtung 8 eine Infrarot-Laserstrahlungsquelle 9, vorzugsweise eine Halbleiterlaserdiode, die vermittels einer elektrisch gekoppelten Steuerung 10 gesteuert ist, und deren Laserstrahlung mit einer Wellenlänge von etwa 950 nm über einen Lichtleiter 11 und optische Fokussierlinsen 12, 13 an einen mit der Lichtstrahlung 14 zu beheizenden Wärmekörper 15 geführt ist. Der Wärmekörper 15 besteht aus einer Quarzplatte, die auf ihrer der Chip-Substrat-Verbindung 1 zugewandten Oberfläche 16 mit einer 100 nm bis etwa 300 nm starken Chrom-Schicht 17 versehen ist. Die Chrom-Schicht 17 dient hierbei als Absorberschicht der Absorption der eingespeisten Laserstrahlung 15, wandelt die eingestrahlte infrarote Lichtenergie in Wärmeenergie um und gibt sie an das wärmemäßig innig mit dem Wärmekörper 15 gekoppelte Substrat 3 und damit an das Lötmittel 4 weiter. Nach einem wesentlichen Gedanken der Erfindung ist somit der das Substrat 3 abstützende Träger 7 gleichzeitig als Bestandteil der Heizeinrichtung 8 ausgebildet, d.h. er stellt den mit der wärmestrahlung von der Quelle 9 beheizten Wärmekörper 15 dar. Mit der erfindungsgemäßen Vorrichtung gelingt es, lediglich die zu verbindenden Bestandteile, also den Halbleiterchip 2 und das Substrat 3 in äußerst kurzen Zeitintervallen von typischerweise weniger als 1 s auf die gewünschte Löttemperatur von etwas mehr als 350° C zu bringen. Dabei kann der nicht zum Aufheizen der zu verbindenden Bestandteile verwendete Anteil der Energie des Lasers 9 möglichst gering gehalten werden. Hilfsweise kann zur Vorheizung eine Heizquelle der vorbekannten Bauart vorgesehen sein, die in der Figur jedoch nicht näher dargestellt ist.

## Patentansprüche

1. Vorrichtung zur Herstellung einer Chip-Substrat-Verbindung (1) insbesondere durch Löten eines Halbleiterchips (2) auf einem Substrat (3), welche Vorrichtung einen Träger (7), auf bzw. an dem das Substrat (3) vorübergehend abgestützt ist, und eine der Chip-Substrat-Verbindung (1) zugeordnete Heizeinrichtung (8) aufweist, wobei die Heizeinrichtung (8) eine Strahlungsquelle (9) besitzt,
**dadurch gekennzeichnet, dass**
der das Substrat (3) vorübergehend abstützende Träger (7) als Bestandteil der Heizeinrichtung (8) einen mittels Lichtstrahlung, insbesondere Laserstrahlung, der Strahlungsquelle (9) beheizbaren Wärmekörper (15) aufweist, wobei der Wärmekörper (15) wärmemäßig innig mit dem Substrat (3) gekoppelt ist und auf seiner der Chip-Substrat-Verbindung (1) zugewandten Oberfläche mit einem Material hoher Absorption (17) in Bezug auf die von der Strahlungsquelle (9) ausgesandte Lichtstrahlung (14) beschichtet ist.

2. Vorrichtung nach Anspruch 1,
**dadurch gekennzeichnet,**
**dass** die Strahlungsquelle (9) ein Laser mit einer Laserstrahlung im Infrarot-Wellenlängenbereich darstellt.

3. Vorrichtung nach Anspruch 2,
**dadurch gekennzeichnet,**
**dass** die Wellenlänge der Laserstrahlung etwa 950 nm beträgt.

4. Vorrichtung nach einem der Ansprüche 1 bis 3,
**dadurch gekennzeichnet, dass** der der Chip-Substrat-Verbindung (1) zugeordnete Wärmekörper der Heizeinrichtung (8) zwei Schichten aufweist, nämlich eine erste Schicht (15), die ein für die Wärmestrahlung der Strahlungsquelle (9) transparentes oder wenigstens durchscheinendes Material aufweist, und eine zweite Schicht, die durch das Material (17) hoher Absorption gebildet ist.

5. Vorrichtung nach Anspruch 4,
**dadurch gekennzeichnet,**
**dass** der Wärmekörper (15) Quarz aufweist.

6. Vorrichtung nach einem der Ansprüche 1 bis 5,
**dadurch gekennzeichnet,**
**dass** der Wärmekörper (15) auf seiner der Chip-Substrat-Verbindung (1) zugewandten Oberfläche (16) mit einer dünnen Chrom-Schicht (17) versehen ist.

7. Vorrichtung nach Anspruch 6,
**dadurch gekennzeichnet,**
**dass** die Ausdehnung des Materials (4) hoher Absorption auf den zu erwärmenden Abschnitt des unmittelbar betroffenen Halbleiterchips (2) der Chip-Substrat-Verbindung (1) begrenzt ist.

8. Verfahren zur Herstellung einer Chip-Substrat-Verbindung (1) insbesondere durch Löten eines Halbleiterchips (2) auf einem Substrat (3), welche Vorrichtung einen Träger (7), auf bzw. an dem das Substrat (3) vorübergehend abgestützt ist, und eine der Chip-Substrat-Verbindung (1) zugeordnete Heizeinrichtung (8) aufweist, wobei die Heizeinrichtung (8) eine Strahlungsquelle (9) besitzt,
**dadurch gekennzeichnet, dass**
der das Substrat (3) vorübergehend abstützende Träger (7) als Bestandteil der Heizeinrichtung (8) einen Wärmekörper (15, 17) aufweist, der mittels Lichtstrahlung, insbesonder Laserstrahlung, der Strahlungsquelle (9) beheizt wird, wobei der Wärmekörper (15, 17) wärmemäßig innig mit dem Substrat (3) gekoppelt ist und auf seiner der Chip-Substrat-Verbindung (1) zugewandten Oberfläche (16) mit einem Material hoher Absorption (17) in Bezug auf die von der Strahlungsquelle (9) ausgesandte Lichtstrahlung (14) versehen ist.

9. Verfahren nach Anspruch 8,
**dadurch gekennzeichnet,**
**dass** als Strahlungsquelle (9) ein Laser mit einer Laserstrahlung im Infrarot-Wellenlängenbereich verwendet wird.

10. Verfahren nach Anspruch 9,
**dadurch gekennzeichnet,**
**dass** die Wellenlänge der Laserstrahlung etwa 950 nm beträgt.

11. Verfahren nach einem der Ansprüche 8 bis 10,
**dadurch gekennzeichnet, dass** der der Chip-Substrat-Verbindung (1) zugeordnete Wärmekörper (15, 17) der Heizeinrichtung (8) auf einer ersten Seite ein für die Wärmestrahlung der Strahlungsquelle (9) transparentes oder wenigstens durchscheinendes Material (15) und auf einer zweiten Seite, an die sich das Substrat (3) anschließt, das Material hoher Absorption (17) aufweist.

12. Verfahren nach Anspruch 11,
**dadurch gekennzeichnet,**
**dass** der Wärmekörper (15) Quarz aufweist.

13. Verfahren nach einen der Ansprüche 8 bis 12,
**dadurch gekennzeichnet,**
**dass** der Wärmekörper (15) auf seiner der Chip-Substrat-Verbindung (1) zugewandten Oberfläche mit einer dünnen Chrom-Schicht (17) versehen ist.

14. Verfahren nach Anspruch 13,
**dadurch gekennzeichnet,**
**dass** die Ausdehnung des Materials (4) hoher Absorption auf den zu erwärmenden Abschnitt des unmittelbar betroffenen Halbleiterchips (2) der Chip-Substrat-Verbindung (1) begrenzt ist.

## Claims

1. Apparatus for producing a chip-substrate connection (1), in particular by soldering a semiconductor chip (2) on a substrate (3), which apparatus has a support (7), on which the substrate (3) is temporarily supported, and a heating device (8) assigned to the chip-substrate connection (1), in which the heating device (8) has a radiation source (9), **characterized in that** the support (7) which temporarily supports the substrate (3) has, as part of the heating device (8), a heat body (15) that can be heated by means of light radiation, in particular laser radiation, from the radiation source (9), the heat body (15) being thermally intimately coupled to the substrate (3) and being coated on its surface which faces the chip substrate connection (1) with a material exhibiting high absorption (17) with respect to the light radiation (14) emitted by the radiation source (9).

2. Apparatus according to Claim 1, **characterized in that** the radiation source (9) constitutes a laser with a laser radiation in the infrared wavelength range.

3. Apparatus according to Claim 2, **characterized in that** the wavelength of the laser radiation is approximately 950 nm.

4. Apparatus according to one of Claims 1 to 3, **characterized in that** the heat body, assigned to the chip-substrate connection (1), of the heating device (8) has two layers, namely a first layer (15) which has a material which is transparent or at least translucent to the thermal radiation from the radiation source (9), and a second layer which is formed by the material (17) exhibiting high absorption.

5. Apparatus according to Claim 4, **characterized in that** the heat body (15) has quartz.

6. Apparatus according to one of Claims 1 to 5, **characterized in that** the heat body (15) is provided with a thin chromium layer (17) on its surface (16) facing the chip-substrate connection (1).

7. Apparatus according to Claim 6, **characterized in that** the extent of the material (4) exhibiting high absorption is limited to that section of the directly affected semiconductor chip (2) of the chip-substrate connection (1) which is to be heated.

8. Method for producing a chip-substrate connection (1), in particular by soldering a semiconductor chip (2) on a substrate (3), which apparatus has a support (7) on which the substrate (3) is temporarily supported, and a heating device (8) assigned to the chip-substrate connection (1), the heating device (8) having a radiation source (9), **characterized in that** the support (7) which temporarily supports the substrate (3) has, as part of the heating device (8), a heat body (15, 17) heated by means of light radiation, in particular laser radiation, from the radiation source (9), the heat body (15, 17) being thermally intimately coupled to the substrate (3) and being provided on its surface (16) which faces the chip substrate connection (1) with a material exhibiting high absorption (17) with respect to the light radiation (14) emitted by the radiation source (9).

9. Method according to Claim 8, **characterized in that** a laser with a laser radiation in the infrared wavelength range is used as the radiation source (9).

10. Method according to Claim 9, **characterized in that** the wavelength of the laser radiation is approximately 950 nm.

11. Method according to one of Claims 8 to 10, **characterized in that** the heat body (15, 17), assigned to the chip-substrate connection (1), of the heating device (8) has, on a first side, a material (15) which is transparent or at least translucent to the thermal radiation from the radiation source (9) and, on a second side adjoined by the substrate (3), the material exhibiting high absorption (17).

12. Method according to Claim 11, **characterized in that** the heat body (15) has quartz.

13. Method according to one of Claims 8 to 12, **characterized in that**, on its side facing the chip-substrate connection (1), the heat body (15) is provided with a thin chromium layer (17).

14. Method according to Claim 13, **characterized in that** the extent of the material (4) exhibiting high absorption is limited to that section of the directly affected semiconductor chip (2) of the chip-substrate connection (1) which is to be heated.

## Revendications

1. Dispositif pour produire une liaison (1) puce-substrat notamment par brasage d'une puce (2) à semi-conducteurs sur un substrat (3), le dispositif comportant un support (7), sur lequel le substrat (3) prend appui provisoirement, et un dispositif (8) de chauffage associé à la liaison (1) puce-substrat, le dispositif (8) de chauffage ayant une source (9) de rayonnement,
**caractérisé en ce que**
le support (7) soutenant provisoirement le substrat (3) comporte, comme partie constitutive du dispositif (8) de chauffage, un corps (15) thermique pouvant être chauffé au moyen d'un rayonnement lumineux, notamment un rayonnement laser, de la source (9) de rayonnement, le corps (15) thermique étant couplé du point de vue thermique de manière intime avec le substrat (3) et étant revêtu sur sa surface tournée vers la liaison (1) puce-substrat d'un matériau de grande absorption (17) du rayonnement (14) lumineux émis par la source (9) de rayonnement.

2. Dispositif suivant la revendication 1,
**caractérisé en ce que**
la source (9) de rayonnement représente un laser ayant un rayonnement laser dans le domaine de longueur d'onde de l'infrarouge.

3. Dispositif suivant la revendication 2,
**caractérisé en ce que**
la longueur d'onde du rayonnement laser est égale à environ 950 nm.

4. Dispositif suivant l'une des revendications 1 à 3,
**caractérisé en ce que**
le corps thermique du dispositif (8) de chauffage associé à la liaison (1) puce-substrat comporte deux couches, à savoir une première couche (15), qui comporte un matériau transparent ou au moins translucide pour le rayonnement thermique de la source (9) de rayonnement, et une deuxième couche, qui est formée par le matériau (17) de grande absorption.

5. Dispositif suivant la revendication 4,
**caractérisé en ce que**
le corps (15) thermique comporte du quartz.

6. Dispositif suivant l'une des revendications 1 à 5,
**caractérisé en ce que**
le corps (15) thermique est muni sur sa surface (16) tournée vers la liaison (1) puce-substrat d'une mince couche (17) de chrome.

7. Dispositif suivant la revendication 6,
**caractérisé en ce que**
la dilatation du matériau (4) de grande absorption sur la partie à chauffer de la puce (2) à semi-conducteurs directement concernée de la liaison (1) puce-substrat est limitée.

8. Procédé pour la production d'une liaison (1) puce-substrat, notamment par brasage d'une puce (2) à semi-conducteurs sur un substrat (3), le dispositif comportant un support (7), sur ou contre lequel le substrat (3) prend appui provisoirement, et un dispositif (8) de chauffage associé à la liaison (1) puce-substrat, le dispositif (8) de chauffage ayant une source (9) de rayonnement,
**caractérisé en ce que**
le support (7) soutenant provisoirement le substrat (3) comporte comme élément constitutif du dispositif (8) de chauffage, un corps (15, 17) thermique qui est chauffé au moyen d'un rayonnement lumineux, notamment d'un rayonnement laser, de la source (9) de rayonnement, le corps (15, 17) thermique étant couplé du point de vue thermique de manière intime avec le substrat (3) et étant muni sur sa surface (16) tournée vers la liaison (1) puce-substrat d'un matériau de grande absorption (17) du rayonnement (14) lumineux émis par la source (9) de rayonnement.

9. Procédé suivant la revendication 8,
**caractérisé en ce que**
l'on utilise comme source (9) de rayonnement un laser ayant un rayonnement laser dans le domaine de longueur d'onde de l'infrarouge.

10. Procédé suivant la revendication 9,
**caractérisé en ce que**
la longueur d'onde du rayonnement laser est égale à environ 950 nm.

11. Procédé suivant l'une des revendications 8 à 10,
**caractérisé en ce que**
le corps (15, 17) thermique, associé à la liaison (1) puce-substrat, du dispositif (8) de chauffage comporte sur sa première partie un matériau (15) transparent ou au moins translucide pour le rayonnement thermique de la source (9) de rayonnement, et sur sa deuxième partie, qui se rattache au substrat (3), le matériau de grande absorption (17).

12. Procédé suivant la revendication 11,
**caractérisé en ce que**
le corps (15) thermique comporte du quartz.

13. Procédé suivant l'une des revendications 8 à 12,
**caractérisé en ce que**
le corps (15) thermique est muni sur sa surface tournée vers la liaison (1) puce-substrat d'une mince couche (17) de chrome.

14. Procédé suivant la revendication 13,
**caractérisé en ce que**
la dilatation du matériau (4) de grande absorption sur la partie à chauffer de la puce (2) à semi-conducteurs directement concernée de la liaison (1) puce-substrat est limitée.
